# EUROPEAN PATENT APPLICATION

(11) **EP 4 625 481 A2**
(43) Date of publication of application: **01.10.2025**
(21) Application number: 25165567.6
(22) Date of filing: 24.03.2025
(51) Int. Cl.: H01L 21/67

(54) **SUBSTRATE PROCESSING APPARATUS**

(30) Priority: 26.03.2024 JP 2024050411
(71) Applicant: Shibaura Mechatronics Corporation, Yokohama-shi, Kanagawa 247-8610 (JP)
(72) Inventor: MATSUSHITA, Jun, Yokohama-shi, Kanagawa, 247-8610 (JP); HOSHINO, Hikaru, Yokohama-shi, Kanagawa, 247-8610 (JP); KAMEI, Kengo, Yokohama-shi, Kanagawa, 247-8610 (JP); TESHIMA, Rie, Yokohama-shi, Kanagawa, 247-8610 (JP)
(74) Representative: Hoffmann Eitle

(57) **Abstract**

A substrate processing apparatus (1) includes: a rotary holder (10) configured to hold and rotate a substrate; a processing liquid supplier (20) configured to supply a processing liquid to the substrate, which is held and rotated by the rotary holder (10); a heater (50) including at least one light emitting element (51, 51A, 51B, 51C, 51D) configured to emit light having a wavelength, which is absorbed in the substrate, and configured to heat the substrate by irradiating the light from the at least one light emitting element (51, 51A, 51B, 51C, 51D) to the substrate, which is held and rotated by the rotary holder (10); and a temperature measurer (70) including a radiation thermometer (71, 71A, 71B, 71C, 71D) configured to measure a temperature of the processing liquid in a non-contact manner, based on light radiated from the processing liquid, and configured to measure the temperature of the processing liquid, which is heated by being in contact with the substrate, by using the radiation thermometer (71, 71A, 71B, 71C, 71D).

## Description

### CROSS-REFERENCE TO RELATED APPLICATION

This application is based upon and claims the benefit of priority from Japanese Patent Application No. 2024-050411, filed on March 26, 2024, the entire contents of which are incorporated herein by reference.

### TECHNICAL FIELD

The present disclosure relates to a substrate processing apparatus.

### BACKGROUND

A single-wafer type substrate processing apparatus in which an etching processing, a resist removal processing, or the like is performed by supplying a processing liquid to a substrate such as a semiconductor wafer while rotating the substrate is known. In this substrate processing apparatus, the substrate being processed or the processing liquid on the substrate is heated by a heater, such that a temperature of the processing liquid is increased, thereby improving a processing efficiency.

### [Prior Art Documents]

### [Patent Documents]

Patent Document 1: Japanese Patent Laid-open Publication No. 2015-211201

In recent years, it has been required to more precisely control a processing amount of a substrate along with miniaturization of a semiconductor device. For this reason, during processing of the substrate, it is necessary to control a processing rate (processing amount per unit time) of the substrate with a high precision.

### SUMMARY

Some embodiments of the present disclosure provide a substrate processing apparatus capable of controlling a processing rate of a substrate with a high precision.

According to an embodiment of the present disclosure, there is provided a substrate processing apparatus, which includes: a rotary holder configured to hold and rotate a substrate; a processing liquid supplier configured to supply a processing liquid to the substrate, which is held and rotated by the rotary holder; a heater including at least one light emitting element configured to emit light having a wavelength, which is absorbed in the substrate, and configured to heat the substrate by irradiating the light from the at least one light emitting element to the substrate, which is held and rotated by the rotary holder; and a temperature measurer including a radiation thermometer configured to measure a temperature of the processing liquid in a non-contact manner, based on light radiated from the processing liquid, and configured to measure the temperature of the processing liquid, which is heated by being in contact with the substrate, by using the radiation thermometer.

### BRIEF DESCRIPTION OF DRAWINGS

The accompanying drawings, which are incorporated in and constitute a part of the specification, illustrate embodiments of the present disclosure.
FIG. 1 is an axial partial cross-sectional view of a substrate processing apparatus of an embodiment when a processing liquid is supplied in the substrate processing apparatus.
FIG. 2 is an axial partial cross-sectional view of the substrate processing apparatus of FIG. 1 when a rinse liquid is supplied in the substrate processing apparatus.
FIG. 3 is an axial partial cross-sectional view of the substrate processing apparatus of FIG. 1 when a substrate is loaded or unloaded in the substrate processing apparatus.
FIG. 4 is a graph illustrating a relationship between wavelengths and transmittances of irradiation light with respect to a phosphoric acid solution and a substrate.
FIG. 5 is a bottom view illustrating a heater.
FIG. 6 is a graph illustrating a relationship between wavelengths and absorbances of irradiation light with respect to phosphoric acid solutions and water.
FIG. 7 is a block diagram of a controller.
FIG. 8 is a flowchart illustrating a processing sequence of the embodiment.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components have not been described in detail so as not to unnecessarily obscure aspects of the various embodiments.

Hereinafter, an embodiment of the present disclosure will be described with reference to the accompanying drawings.

### [Outline]

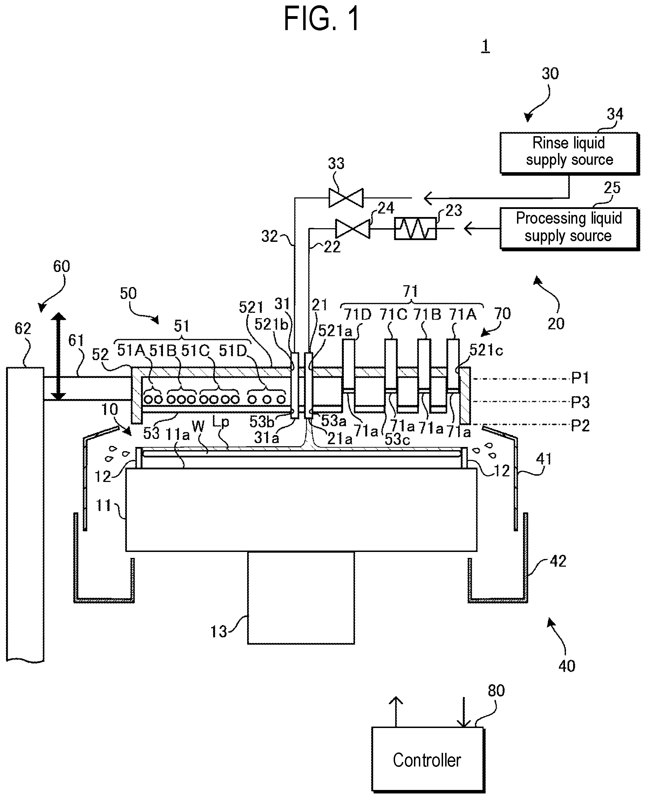

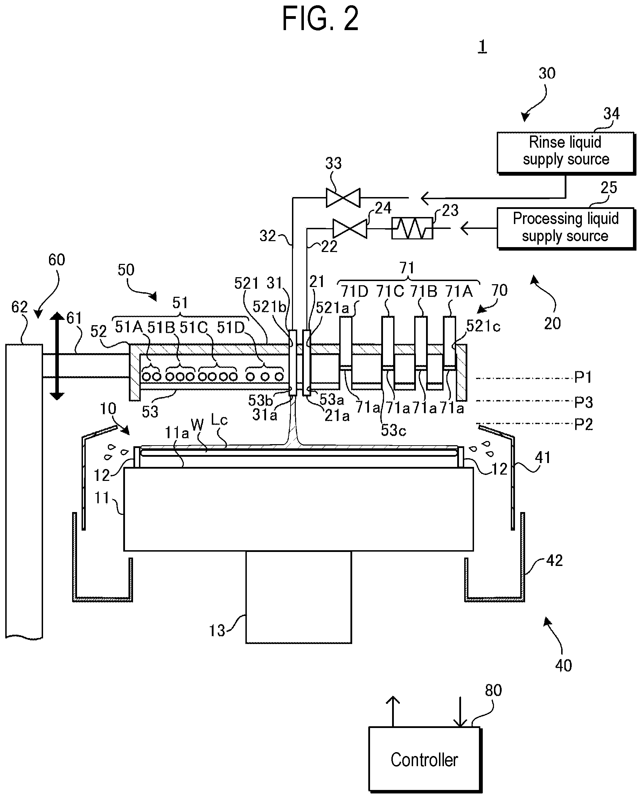

As illustrated in FIG. 1, a substrate processing apparatus 1 processes a substrate W held by a rotary holder 10 by supplying a processing liquid Lp from a processing liquid supplier 20 to the substrate W while rotating the substrate W. The substrate processing apparatus 1 of the present embodiment is a single-wafer type apparatus configured to perform an etching processing by supplying the processing liquid Lp having an etching ability to the substrate W. In addition, in the present embodiment, as shown in FIG. 2, a rinse processing is performed by supplying a rinse liquid Lc from a rinse liquid supplier 30 to the substrate W before and after supplying the processing liquid Lp.

The substrate processing apparatus 1 includes a heater 50 constituted by a light emitting element 51 and a temperature measurer 70 constituted by a radiation thermometer 71. The light emitting element 51 is an LED configured to heat the substrate W itself by irradiating light with a wavelength, which heats the substrate W. A measurement wavelength of the radiation thermometer 71 is a wavelength at which a temperature of the processing liquid Lp itself on the substrate W may be measured. A controller 80 adjusts an output of light emitting element 51, based on the measured temperature of the processing liquid Lp. That is, in the substrate processing apparatus 1, a heating target (substrate W) and a temperature measurement target (processing liquid Lp) are different from each other.

The substrate W processed according to the present embodiment is, for example, a disc-shaped silicon wafer (hereinafter, referred to as a Si substrate) in which a silicon nitride film and a silicon oxide film are formed on a surface thereof. The processing liquid Lp is, for example, an aqueous solution (hereinafter, referred to as a phosphoric acid solution) containing a phosphoric acid. The concentration of the phosphoric acid in the processing liquid Lp is, for example, 85 wt% to 94 wt%. The rinse liquid Lc is, for example, pure water (H₂O).

### (Control of Processing Rate based on Temperature Measurement)

A processing rate of the substrate W depends on the temperature of the substrate W. For this reason, to control the processing rate, for example, a heater configured to heat the substrate W and a thermometer configured to measure a temperature of the substrate W are connected to a controller, thereby measuring the temperature of the substrate W while heating the substrate W to which the processing liquid Lp is supplied. The controller controls the processing rate by adjusting the output of the heater such that the temperature of the substrate W is maintained as a target temperature by comparing the measured temperature of the substrate W with the target temperature.

As the thermometer, for example, a radiation thermometer may be used. The radiation thermometer is a thermometer configured to calculate a temperature of an object which is a measurement target by measuring an intensity of an electromagnetic wave such as infrared light or visible light, which is radiated from the object, and correcting the intensity based on an emissivity of the object. However, the emissivity of the object depends on material or a surface state of the object. Therefore, when a kind of the substrate W varies, the emissivity also varies. The kind of the substrate W is, specifically, a kind of material forming the substrate W, a film formed on the surface of the substrate W, or a pattern (unevenness) formed at the surface of the substrate W. For this reason, to accurately measure the temperature of the substrate W by using the radiation thermometer, an effort is taken to obtain in advance an emissivity for each kind of the substrate W and individually adjust setting of the radiation thermometer according to the kind of the substrate W.

Accordingly, inventors of the present disclosure have developed the substrate processing apparatus 1 of an embodiment, which will be described below, as a result obtained by making a close study on a technique of obtaining temperature information with a high precision even when the adjustment of the radiation thermometer is not individually performed according to another kind of the substrate W. Like the present embodiment, when accurate temperature information may be obtained, it is possible to allow a variation in the output of the light emitting element 51, which is necessary for the target temperature, to become more accurate. Further, by a change in the output of the light emitting element 51, the temperature of the processing liquid Lp may be maintained as the target temperature, and thus it is possible to control the processing rate of the substrate W with high precision.

### [Configuration]

As illustrated in FIG. 1, the substrate processing apparatus 1 of the present embodiment includes the rotary holder 10, the processing liquid supplier 20, the rinse liquid supplier 30, a liquid accommodator 40, the heater 50, an elevator 60, the temperature measurer 70, and the controller 80.

### (Rotary Holder)

The rotary holder 10 holds and rotates the substrate W. The rotary holder 10 includes a rotating table 11, a chuck pin 12, and a driver 13. The rotating table 11 is a cylindrical member, and one end of the rotating table 11 is blocked by an opposite surface 11a. The opposite surface 11a is a circular surface having a diameter larger than that of the substrate W, and is opposite to the substrate W as a processing target at an interval.

The chuck pin 12 is a holding tool configured to hold the substrate W at an interval from the opposite surface 11a of the rotating table 11. A plurality of chuck pins 12 are provided at an equal interval along positions corresponding to an outer circumference of the substrate W while protruding on the rotating table 11. Further, by an opening/closing mechanism which is not illustrated, the chuck pin 12 is provided to be movable between a closing position at which the chuck pin 12 holds the substrate W while being in contact with the outer circumference of the substrate W and an opening position at which the chuck pin 12 is spaced apart from the outer circumference of the substrate W to releases the substrate W.

The driver 13 is a driving source (motor) configured to rotate the rotating table 11. The driver 13 rotates the rotating table 11, to rotate the substrate W held by the chuck pin 12.

### (Processing Liquid Supplier)

The processing liquid supplier 20 supplies the processing liquid Lp to the substrate W held and rotated by the rotary holder 10. The processing liquid supplier 20 includes a processing liquid nozzle 21, a processing liquid supply pipe 22, a heater 23, and a valve 24. The processing liquid nozzle 21 is provided to penetrate a support 52 and a cover 53 of the heater 50, which will be described later, such that a front-end discharge port 21a is opposite to the vicinity of a center of the substrate W held by the rotary holder 10.

The processing liquid nozzle 21 is connected to a processing liquid supply source 25 such as a tank, in which the processing liquid Lp is stored, via the processing liquid supply pipe 22. In the present embodiment, the processing liquid Lp delivered from the processing liquid supply source 25 is heated in advance. The heater 23 is provided in the middle of the processing liquid supply pipe 22. The processing liquid Lp delivered from the processing liquid supply source 25 is heated by the heater 23 while passing through the processing liquid supply pipe 22, and then discharged to the vicinity of the center of the substrate W from the discharge port 21a of the processing liquid nozzle 21.

A temperature of the processing liquid Lp discharged from the processing liquid nozzle 21 is, for example, 160 degrees C. In addition, the valve 24 is provided in the middle of the processing liquid supply pipe 22. The valve 24 is opened or closed, such that the discharge of the processing liquid Lp from the processing liquid nozzle 21 is started or stopped. The valve 24 is electrically connected to the controller 80 which will be described later, such that the valve 24 is controlled to be opened or closed by the controller 80.

### (Rinse Liquid Supplier)

As illustrated in FIG. 2, the rinse liquid supplier 30 supplies the rinse liquid Lc to the substrate W held by the rotary holder 10. As the rinse liquid Lc, for example, pure water may be used. The rinse liquid supplier 30 includes a rinse liquid nozzle 31, a rinse liquid supply pipe 32, and a valve 33. The rinse liquid nozzle 31 is provided to penetrate the support 52 and the cover 53 of the heater 50, which will be described later, such that a front-end discharge port 31a is opposite to the vicinity of the center of the substrate W held by the rotary holder 10.

The rinse liquid nozzle 31 is connected to a rinse liquid supply source 34 such as a tank, in which the rinse liquid Lc is stored, via the rinse liquid supply pipe 32. The rinse liquid Lc delivered from the rinse liquid supply source 34 is discharged to the vicinity of the center of the substrate W from the discharge port 31a of the rinse liquid nozzle 31 after passing through the rinse liquid supply pipe 32. The valve 33 is provided in the middle of the rinse liquid supply pipe 32. The valve 33 is opened or closed such that the discharge of the rinse liquid Lc from the rinse liquid nozzle 31 is started or stopped. The valve 33 is electrically connected to the controller 80, which will be described later, such that the valve 33 is controlled to be opened or closed by the controller 80.

### (Liquid Accommodator)

The liquid accommodator 40 surrounds the rotary holder 10, to receive the processing liquid Lp and the rinse liquid Lc, which are scattered from the rotating substrate W. The liquid accommodator 40 discharges the received processing liquid Lp and the received rinse liquid Lc out of the substrate processing apparatus 1.

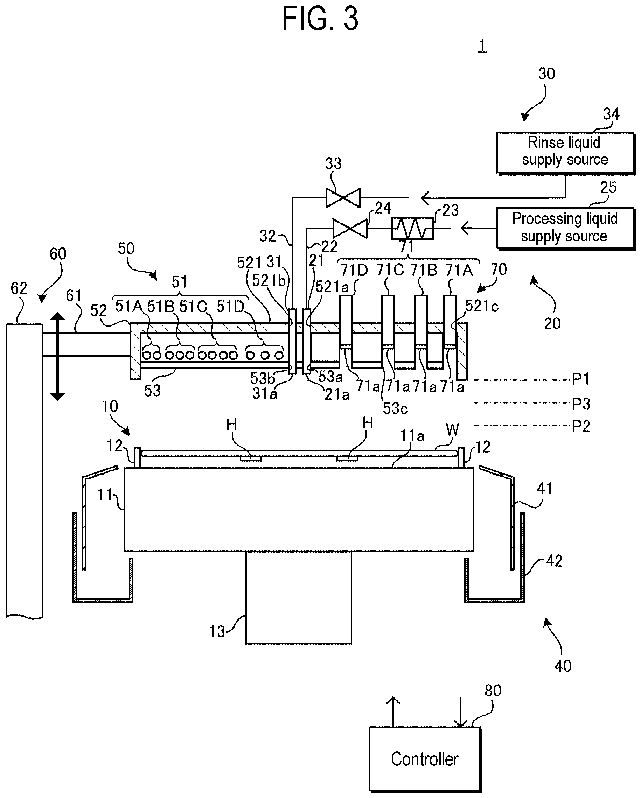

The liquid accommodator 40 includes a cup part 41 and an accommodator 42. The cup part 41 is a cylindrical body which covers the periphery of the rotary holder 10 at an interval and is bent such that an upper diameter shrinks. By an elevator which is not illustrated, the cup part 41 is provided to be movable between a waiting position *(see* FIG. 3) and a processing position *(see* FIGS. 1 and 2). The accommodator 42 is an annular container which is provided below the cup part 41 and has an open top.

Since the processing liquid Lp and the rinse liquid Lc, which are scattered from the substrate W, are received by the cup part 41 and drop downward along an inner wall of the cup part 41, the processing liquid Lp and the rinse liquid Lc are introduced into the accommodator 42. The processing liquid Lp and the rinse liquid Lc, which are introduced into the accommodator 42, are discharged out of the substrate processing apparatus 1 from a discharge port (not illustrated), which is formed at a bottom of the accommodator 42.

### (Heater)

The heater 50 heats the substrate W by irradiating light from the light emitting element 51 to the substrate W held and rotated by the rotary holder 10. The processing liquid Lp supplied to the vicinity of the center of the substrate W flows to spread in an outer circumferential direction of the substrate W by a centrifugal force. At this time, when heat is no longer applied, the temperature of the supplied processing liquid Lp of high-temperature (160 degrees C) is decreased as the processing liquid Lp flows on the substrate W, due to heat conduction or heat radiation to the substrate W. Thus, the substrate W is heated, such that the processing liquid Lp on the substrate W may be heated by the heat conduction from the substrate W, thereby maintaining the processing liquid Lp on the substrate W at a high temperature. In addition, the output of the heater 50 may be controlled not only to maintain the temperature of the processing liquid Lp but also to further increase the temperature of the processing liquid Lp on the substrate W.

The light emitting element 51 emits light (electromagnetic wave) having a wavelength that is absorbed in the substrate W to heat the substrate W. In addition, the light emitted from the light emitting element 51 is light having a wavelength that is transmitted through the processing liquid Lp. Herein, "being absorbed in the substrate W" refers to that light incident on the substrate W is absorbed in the substrate W such that the substrate W may be sufficiently heated, and includes not only a case where the light is completely absorbed in the substrate W but also a case where a portion of the light is reflected from the substrate W or transmitted through the substrate W. "Being transmitted through the processing liquid Lp" refers to that light incident on the processing liquid Lp is transmitted through the processing liquid Lp such that the substrate W may be sufficiently heated, and includes a case where a portion of the light is absorbed in the processing liquid Lp or reflected from the processing liquid Lp.

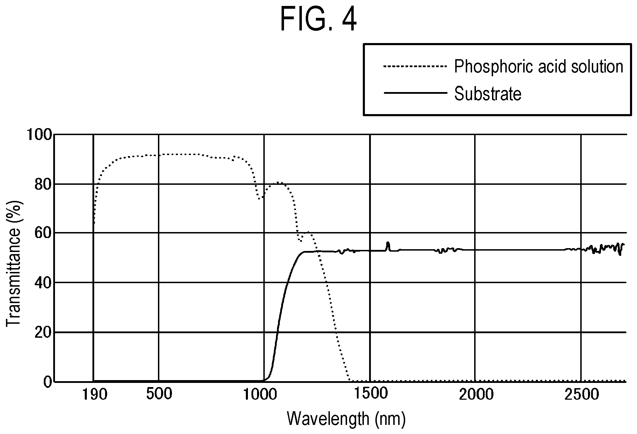

As the light emitting element 51, for example, an LED configured to emit light for heating is used. A wavelength of the light emitted from the LED is, for example, 350 nm to 1060 nm (350 nm or more and 1060 nm or less). More preferably, a center wavelength of the light is 395 nm to 940 nm (395 nm or more and 940 nm or less). In the present embodiment, an LED which emits light with a center wavelength of 395 nm is used. In addition, the output of the light emitting element 51 is controlled by the controller 80 which will be described later. FIG. 4 illustrates transmission spectra with respect to a phosphoric acid solution and a Si substrate. In addition, in measurement of each transmission spectrum, an UV-Visible/NIR Spectrophotometer (V-770) manufactured by JASCO Corporation is used. As illustrated in the graph of FIG. 4, the wavelength of 350 nm to 1060 nm is a wavelength which has a high transmittance (transmittance of 70% or more) with respect to the phosphoric acid solution and has a high absorbance (transmittance of approximately 0%) with respect to the Si substrate.

Accordingly, although light from the light emitting element 51 is irradiated from above a space in which the substrate W is held, i.e., from above the processing liquid Lp supplied on the substrate W, the light is capable of being absorbed in the substrate W while being transmitted through the processing liquid Lp on the substrate W, to heat the substrate W. Further, the temperature of the processing liquid Lp is increased by heat conduction from the substrate W, such that the etching rate (processing rate) of the substrate W increases.

The heater 50 includes the support 52 and the cover 53 in addition to the light emitting element 51. The support 52 is a member configured to support a plurality of light emitting elements 51. The support 52 is a cylindrical member whose top end is blocked by a ceiling plate 521. A diameter of the support 52 is equal to that of the substrate W or is larger than that of the substrate W. The support 52 is located at a position where the support 52 is opposite to the opposite surface 11a at an interval above the rotating table 11. Therefore, the heater 50 is provided to irradiate the light from the light emitting element 51 from above the space in which the substrate W is held by the rotary holder 10. In addition, two through-holes 521a and 521b are provided in the vicinity of the center of the ceiling plate 521 of the support 52.

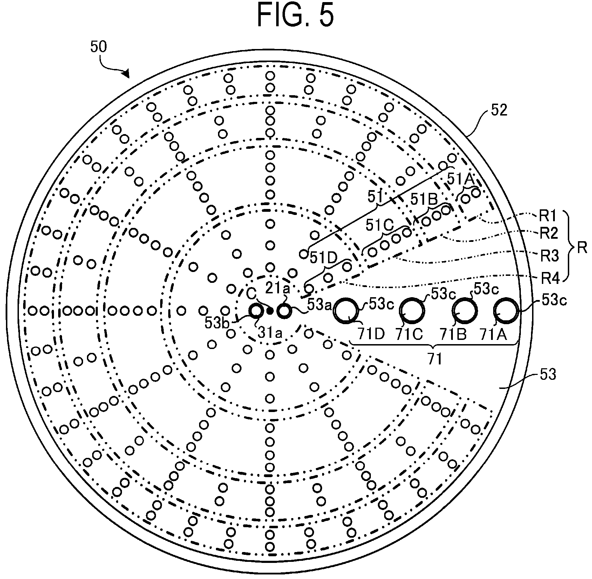

As illustrated in FIG. 5, the cover 53 is a disc-shaped member configured to cover an end of the support 52 that is opposite to the rotating table 11. The cover 53 has a tolerance against the processing liquid Lp, and is made of material through which the light emitted from the light emitting element 51 is transmitted. For example, the cover 53 made of quartz is used. In addition, two through-holes 53a and 53b are formed in the vicinity of the center C of the cover 53. In addition, in FIG. 5, the light emitting element 51 viewed through the cover 53 is indicated by a solid line.

As illustrated in FIG. 1, the processing liquid nozzle 21 penetrates the through-holes 521a and 53a such that the front-end discharge port 21a is exposed from the cover 53 to face the substrate W. The rinse liquid nozzle 31 penetrates through the through-holes 521b and 53b such that the front-end discharge port 31a is exposed from the cover 53 to face the substrate W.

In the support 52, the plurality of light emitting elements 51 are installed to be opposite to the rotating table 11 with the cover 53 interposed therebetween. The heater 50 includes a plurality of regions in which the light emitting elements 51 are arranged. That is, the plurality of light emitting elements 51 may be dividedly arranged in the plurality of regions. In the present embodiment, the light emitting elements 51 are provided in regions corresponding to positions at which radial directions of the substrate W are different from each other, and the output of the light emitting element 51 may be controlled for each region. In addition, the plurality of light emitting elements 51 are arranged such that light may be irradiated on an entire surface of the substrate W to be processed.

For example, as illustrated in FIG. 5, a plurality of light emitting elements 51A to 51D are dividedly arranged in four annular regions R1 to R4 (indicated by alternate long and two short dashes lines in the drawing) on concentric circles, such that the output of light emitting elements may be controlled for each of the regions R1 to R4. A fan-shaped region in which the temperature measurer 70 to be described later is located is excluded from each of the regions R1 to R4, and hence the light emitting elements 51 are not located in the corresponding fan-shaped region. In the following description, when the regions R1 to R4 are not distinguished from each other, the regions R1 to R4 are simply referred to as regions R. In addition, when the light emitting elements 51A to 51D are not distinguished from each other, the light emitting elements 51A to 51D are simply referred to as light emitting elements 51.

In addition, in FIG. 5, to easily identify the regions R, intervals of light emitting elements 51, which correspond to boundaries of the respective region R, becomes large. However, all the intervals of the light emitting elements 51 may be uniform as long as controlled regions R are distinguished from each other. In addition, the number of light emitting elements 51 is not limited to that illustrated in FIG. 5. For example, hundreds to thousands of light emitting elements 51 may be densely arranged in the entire areas. The substrate W is rotated with respect to the plurality of light emitting elements 51, such that the entire surface of the substrate W may be heated by irradiating light on the entire substrate W.

### (Elevator)

As illustrated in FIG. 1, the elevator 60 elevates the heater 50 while supporting the heater 50. The elevator 60 includes an arm 61 and a support 62. The arm 61 is a member extending in a direction parallel to the substrate W, an outer circumferential portion of the support 52 is connected to an end of the arm 61. The support 62 is installed upward in a direction orthogonal to the substrate W, to support the other end of the arm 61. The support 62 is provided to be movable upward or downward by a driving source such as a ball screw mechanism or a cylinder (not shown).

The heater 50 is located at any one of a loading/unloading position P1, a heating position P2, and a rinsing position P3 by driving of the elevator 60. Each position is as follows.

The loading/unloading position P1: a height position at which the heater 50 is upwardly spaced apart from the rotating table 11 such that a hand H of a transfer robot is insertable *(see* FIG. 3).

The heating position P2: a height position closer to the substrate W than the loading/unloading position P1 *(see* FIG. 1). However, the heater 50 is not in contact with the processing liquid Lp on the substrate W.

The rinsing position P3: a height position between the loading/unloading position P1 and the heating position P2 *(see* FIG. 2).

### (Temperature Measurer)

The temperature measurer 70 measures a temperature of the processing liquid Lp heated by being in contact with the substrate W, by using the radiation thermometer 71. The radiation thermometer 71 is a thermometer configured to output an electrical signal according to temperature by condensing light (electromagnetic wave) radiated from an object on a detection element. The radiation thermometer 71 of the present embodiment measures a temperature of the processing liquid Lp in a non-contact manner, based on light radiated from the processing liquid Lp. More specifically, the radiation thermometer 71 receives light radiated from the processing liquid Lp by using a light receiver 71a, to calculate a temperature of the processing liquid Lp according to an intensity of the received light.

The radiation thermometer 71 is provided at each of positions corresponding to the plurality of regions R. That is, radiation thermometers 71 are provided such that the number of the radiation thermometers 71 corresponds to that of the plurality of regions R. In the present embodiment, four radiation thermometers 71A to 71D are fixed to the support 52, corresponding to the regions R1 to R4. In addition, when the radiation thermometers 71A to 71D are not distinguished from each other, the radiation thermometers 71A to 71D are simply referred to as radiation thermometers 71.

More specifically, as illustrated in FIGS. 1 and 5, through-hole 521c and 53c are formed on a circumference corresponding to each of the regions R1 to R4 in which the light emitting elements 51 are located, in a fan-shaped region of the cover 53 and the support 52 in which the light emitting elements 51 are not located. Four through-holes 521c of the support 52 and four through-holes 53c of the cover 53 are provided corresponding to the four regions R1 to R4, respectively.

The radiation thermometers 71A to 71D are inserted into the through-holes 521c, respectively, and the light receiver 71a is fixed to face the substrate W held by the rotary holder 10 through each through-hole 53c. The radiation thermometer 71 is electrically connected to the controller 80. The measurement wavelength of the radiation thermometer 71 is a wavelength at which the intensity of light radiated from the processing liquid Lp may be measured. In addition, the measurement wavelength of the radiation thermometer 71 and the wavelength of light emitted from the light emitting element 51 are preferably different wavelengths. The measurement wavelength of the radiation thermometer 71 and the wavelength of light emitted from the light emitting element 51 are different wavelengths, such that generation of stray light with respect to the radiation thermometer 71 may be prevented, thereby suppressing a measurement error.

For example, when the processing liquid Lp is a phosphoric acid solution, the measurement wavelength is preferably 2.2 *µ*m to 2.4 *µ*m (2.2 *µ*m or more and 2.4 *µ*m or less). In the present embodiment, the measurement wavelength is 2.3 *µ*m. The reason that the measurement wavelength of 2.2 *µ*m to 2.4 *µ*m is preferable is as follows.

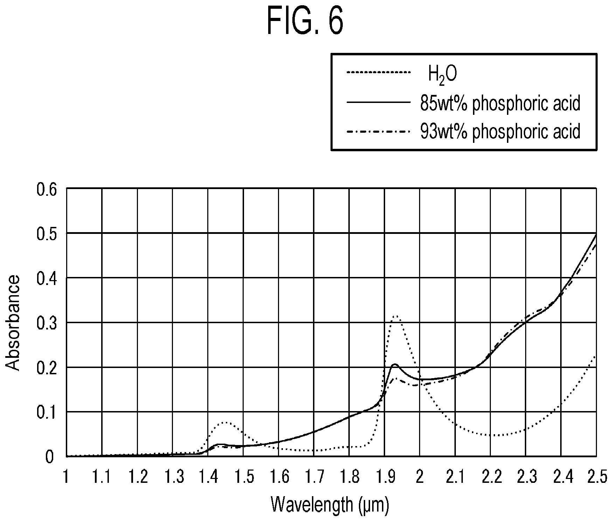

That is, FIG. 6 illustrates absorption spectra of phosphoric acid solutions (concentrations of 85 wt% and 93 wt%) and water (H₂O) in a range of 1 *µ*m to 2.5 *µ*m, by using an infrared spectroscopy. In addition, measurement is made by using an UV-Vis-NIR Spectrophotometer (SolidSpec-3700DUV) manufactured by Shimadzu Corporation.

As can be recognized from FIG. 6, at the wavelength of 2.2 *µ*m to 2.4 *µ*m, the absorbance of the phosphoric acid solution is high, and the absorbance of the water is low. That is, the wavelength of 2.2 *µ*m to 2.4 *µ*m is a wavelength having a high intensity ratio of the phosphoric acid solution and the water. The wavelength is used as the measurement wavelength of the radiation thermometer 71, such that, even when steam is generated in a processing, the temperature of the processing liquid Lp may be measured while suppressing an influence of the steam.

### (Controller)

The controller 80 controls each part of the substrate processing apparatus 1. The controller 80 includes a processor configured to execute a program to implement various functions of the substrate processing apparatus 1, a memory configured to store various information such as a program or an operation condition, and a driving circuit configured to drive each element. That is, the controller 80 controls the rotary holder 10, the processing liquid supplier 20, the rinse liquid supplier 30, the liquid accommodator 40, the heater 50, the elevator 60, the temperature measurer 70, and the like.

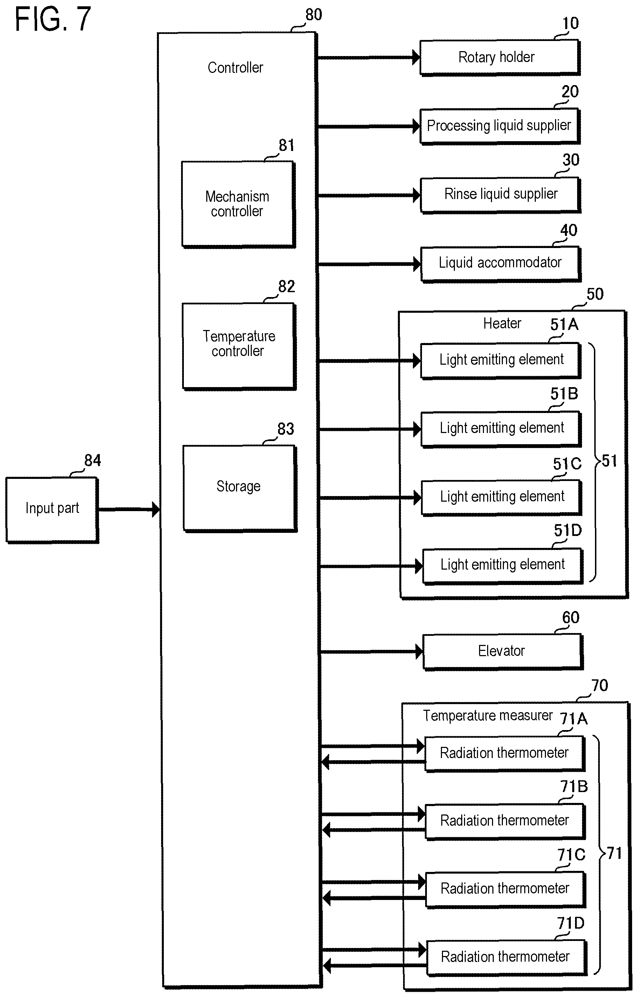

More specifically, as illustrated in FIG. 7, the controller 80 includes a mechanism controller 81, a temperature controller 82, and a storage 83. The mechanism controller 81 controls operations of the opening/closing mechanism and the driver 13 of the rotary holder 10, the heater 23 and the valve 24 of the processing liquid supplier 20, the valve 33 of the rinse liquid supplier 30, an elevator of the liquid accommodator 40, the elevator 60, and the like.

The temperature controller 82 controls a heating temperature of the substrate W by the heater 50, based on the temperature of the processing liquid Lp, which is measured by the temperature measurer 70. The storage 83 stores information necessary for processing of each part of the substrate processing apparatus 1. For example, the storage 83 stores a target temperature of the processing liquid Lp and an emissivity of the processing liquid Lp.

The radiation thermometer 71 corrects a measured light intensity, based on the emissivity of the processing liquid Lp, which is stored in the storage 83 in advance, and calculates a temperature of the processing liquid Lp on the substrate W. Then, the radiation thermometer 71 transmits the calculated temperature to the controller 80. The temperature controller 82 heats the substrate W by adjusting the light intensity of the light emitting element 51 of the heater 50 such that the temperature of the processing liquid Lp becomes the target temperature. At this time, the light intensity of each of the light emitting elements 51A to 51D is adjusted according to the temperature of the processing liquid Lp, which is measured by each of the radiation thermometers 71A to 71D in the regions R1 to R4, thereby controlling the temperature of the processing liquid Lp in each of the regions R1 to R4. That is, the controller 80 controls the output of light emitting elements 51 for each of the plurality of regions R based on the temperature of the substrate W measured by the radiation thermometer 71.

In addition, an input part 84 is connected to the controller 80. The input part 84 is constituted as, for example, a touch panel, a keyboard, a mouse, or the like. An operator may input, through the input part 84, information necessary for processing of the substrate W, such as the target temperature of the processing liquid Lp and the emissivity of the processing liquid Lp.

### (Operation)

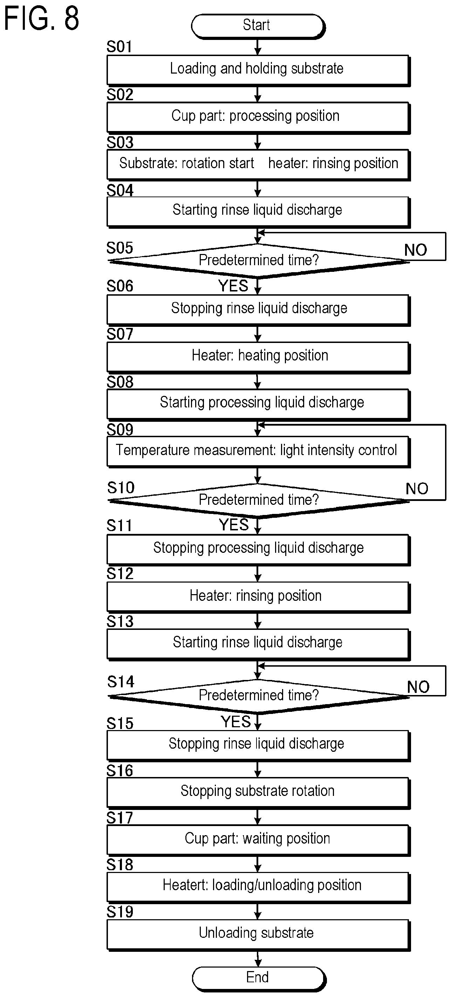

An operation of the substrate processing apparatus 1 of the present embodiment described above will be described with reference to a flowchart of FIG. 8 in addition to FIGS. 1 to 7. In addition, a substrate processing method of processing the substrate W in the following sequence is an aspect of the present embodiment.

As shown in FIG. 3, the heater 50 is located in advance at the loading/unloading position P1, and the cup part 41 is located at the waiting position. The valve 24 of the processing liquid supplier 20 and the valve 33 of the rinse liquid supplier 30 are closed.

In this state, as the chuck pin 12 is located at the opening position, the substrate W mounted on the hand H of the transfer robot is loaded between the heater 50 and the rotating table 11, and then the chuck pin 12 is located at the closing position, such that the circumference of the substrate W is supported by the chuck pin 12. Therefore, above the opposite surface 11a of the rotating table 11, the substrate W is held at an interval from the opposite surface 11a (step S01). At this time, the position of the substrate W is determined such that the center of the substrate W and the rotation axis of the rotating table 11 coincide. Then, the cup part 41 is moved up and located at the processing position (step S02).

Subsequently, as illustrated in FIG. 2, the rotating table 11 rotates, such that as the substrate W held by the chuck pin 12 starts rotating, the heater 50 is moved down to be located at the rinsing position P3 (step S03).

In addition, the valve 33 of the rinse liquid supplier 30 is opened, such that the rinse liquid Lc is discharged to the vicinity of the center of the substrate W from the rinse liquid nozzle 31 (step S04). When the rinse liquid Lc is supplied to the rotating substrate W, the rinse liquid Lc sequentially moves toward the outer circumference of the substrate W to spread on the entire surface of the substrate W to be processed.

In a case where the rinse liquid Lc is not supplied, the processing liquid Lp does not spread on and wet the entire surface of the substrate W to be processed, due to surface tension when the processing liquid Lp is supplied, and therefore, processing non-uniformity occurs. In the present embodiment, to prevent such processing non-uniformity, the rinse liquid Lc is supplied in this step before the processing liquid Lp is supplied. When a predetermined rinsing time elapses ("YES" in step S05), the valve 33 of the rinse liquid supplier 30 is closed, such that the discharge of the rinse liquid Lc from the rinse liquid nozzle 31 is stopped (step S06).

Subsequently, as illustrated in FIG. 1, the heater 50 starts moving down, and stops when reaching the heating position P2 (step S07). In addition, the valve 24 of the processing liquid supplier 20 is opened, such that the processing liquid Lp is discharged to the vicinity of the center of the substrate W from the processing liquid nozzle 21 (step S08). When the processing liquid Lp is supplied to the rotating substrate W, the processing liquid Lp sequentially moves toward the outer circumference of the substrate W to spread on the entire surface of the substrate W to be processed. Since the rinse liquid Lc is supplied in advance to the surface of the substrate W to be processed, the processing liquid Lp spreads on and wet the entire surface of the substrate W to be processed, and thus the processing non-uniformity is prevented.

As the processing liquid Lp starts being discharged, heating of the substrate W by irradiation of light from the light emitting element 51 and temperature measurement of the processing liquid Lp by the radiation thermometer 71 are started. The temperature controller 82 of the controller 80 feedback-controls the output of the light emitting element 51 based on a temperature measurement result of the processing liquid Lp during the heating of the substrate W, such that the temperature of the processing liquid Lp on the substrate W is maintained at a target temperature (step S09). Even in a case where steam (H₂O) is generated by heating, the temperature of the processing liquid Lp may be measured by the radiation thermometer 71 because absorbance of water is low at the measurement wavelength of the radiation thermometer 71 and therefore influence of the steam is suppressed. Such a processing is continued until a predetermined processing time elapses ("NO" in step S10).

When the predetermined processing time elapses ("YES" in step S10), the valve 24 of the processing liquid supplier 20 is closed, such that the supply of the processing liquid Lp from the processing liquid nozzle 21 is stopped (step S11). At the same time, the irradiation of the light from the light emitting element 51 and the temperature measurement by the radiation thermometer 71 are stopped.

As illustrated in FIG. 2, the heater 50 starts moving up, and stops when reaching the rinsing position P3 (step S12). In addition, the valve 33 of the rinse liquid supplier 30 is opened, such that the rinse liquid Lc is discharged to the vicinity of the center of the substrate W from the rinse liquid nozzle 31 (step S13). When the rinse liquid Lc is supplied to the rotating substrate W, the rinse liquid Lc sequentially moves toward the outer circumference of the substrate W to spread on the entire surface of the substrate W to be processed.

When the rinse liquid Lc is supplied to the processing liquid Lp which is a phosphoric acid solution, a large amount of steam is generated. At this time, since the heater 50 is located at the rinsing position P3 which is a position spaced further apart from the substrate W than the heating position P2, attachment of the steam to the heater 50 may be suppressed. In addition, since the rinsing position P3 is a position closer to the substrate W than the loading/unloading position P1, splash of liquid may be suppressed, and thus attachment of droplets to the heater 50 may be suppressed.

When a predetermined rinsing time elapses ("YES" in step S14), the valve 33 of the rinse liquid supplier 30 is closed, such that the discharge of the rinse liquid Lc from the rinse liquid nozzle 31 is stopped (step S15). The rotating table 11 is stopped, such that the rotation of the substrate W held by the chuck pin 12 is stopped (step S16). After that, the cup part 41 moves down to be located at the waiting position (step S17).

As illustrated in FIG. 3, the heater 50 moves up to be located at the loading/unloading position P1 (step S18). In this state, the hand H of the transfer robot is inserted below the substrate W, and the chuck pin 12 is located at the opening position, such that the substrate W is placed on the hand H of the transfer robot, and unloaded to the outside (step S19). At this time, the rinse liquid Lc is held on the substrate W.

### [Effects]

(1) The substrate processing apparatus 1 of the present embodiment includes the rotary holder 10 configured to hold and rotate the substrate W, the processing liquid supplier 20 configured to supply the processing liquid Lp to the substrate W held and rotated by the rotary holder 10, and the heater 50 including the light emitting element 51 configured to emit light having a wavelength, which is absorbed in the substrate W, and configured to heat the substrate W by irradiating the light from the light emitting element 51 to the substrate W, which is held and rotated by the rotary holder 10, and the temperature measurer 70 including the radiation thermometer 71 configured to measure a temperature of the processing liquid Lp in a non-contact manner, based on the light radiated from the processing liquid Lp, and configured to measure the temperature of the processing liquid Lp, which is heated by being in contact with the substrate W, by using the radiation thermometer 71.

For this reason, while heating the substrate W, the temperature of the processing liquid Lp which is in contact with the substrate W instead of the temperature of the substrate W is measured, such that the processing rate of the substrate W may be controlled with high precision. When the kind of substrate W varies as described above, the emissivity also varies. Therefore, to accurately measure the temperature of the substrate W by using the radiation thermometer 71, it is necessary to calculate an emissivity for each kind of the substrate W and set the emissivity in the radiation thermometer 71.

Meanwhile, in the present embodiment, the temperature of the processing liquid Lp instead of the temperature of the substrate W is measured by using the radiation thermometer 71. That is, the measurement wavelength of the radiation thermometer 71 is set as a wavelength at which the intensity of light radiated from the processing liquid Lp may be measured. As long as the emissivity set in the radiation thermometer 71 is the emissivity of the processing liquid Lp, it is unnecessary to calculate an emissivity for each kind of the substrate W and set the emissivity in the radiation thermometer 71. In addition, the substrate W is heated by the light emitting element 51, such that the processing liquid Lp is also heated by heat conduction from the heated substrate W. For this reason, the temperature change of the processing liquid Lp follows the temperature change of the substrate W. The intensity of light radiated from the processing liquid Lp is measured, such that temperature information on another kind of substrate W may be obtained. Further, the output of the light emitting element 51 is changed based on the temperature information, such that the processing rate may be controlled.

(2) The light from the light emitting element 51 is light having a wavelength that is transmitted through the processing liquid Lp, and the heater 50 is provided to irradiate the light from the light emitting element 51 from above the space in which the substrate W is held by the rotary holder 10.

As such, the light having the wavelength that is transmitted through the processing liquid Lp is irradiated from above the substrate W, such that the substrate W may be heated by using, as a starting point, the surface of the substrate W to be processed. That is, the substrate W may be heated by using, as the starting point, an interface of the substrate W with the processing liquid Lp, and thus the processing liquid Lp on the substrate W may be efficiently heated.

(3) The processing liquid Lp supplied by the processing liquid supplier 20 is a solution containing a phosphoric acid, and the measurement wavelength of the radiation thermometer 71 is 2.2 *µ*m to 2.4 *µ*m. For this reason, the temperature of the processing liquid Lp may be measured while suppressing the influence of steam. That is, when the heated processing liquid Lp is discharged or when the rinse liquid Lc is supplied to the processing liquid Lp on the heated substrate W, steam (vapor) is generated. When vapor exists on an optical path of the radiation thermometer 71, even light radiated from the steam is detected, and therefore, the measurement result of the radiation thermometer 71 may be influenced. That is, the intensity of light radiated from the processing liquid Lp on the substrate W may not be correctly measured, and therefore, it is likely that the measured temperature will be different from an actual temperature.

As described above, at the wavelength of 2.2 *µ*m to 2.4 *µ*m, the absorbance of the phosphoric acid solution is high, and the absorbance of the water is low (FIG. 6). That is, the wavelength of 2.2 *µ*m to 2.4 *µ*m is a wavelength having a high intensity ratio of the phosphoric acid solution and the water. For this reason, the measurement wavelength of the radiation thermometer 71 is set to 2.2 *µ*m to 2.4 *µ*m, such that even when steam is generated, the temperature of the processing liquid Lp may be measured while suppressing the influence of the steam. As such, a wavelength at which the absorbance of the processing liquid Lp is high and the absorbance of the water is low, i.e., a wavelength at which the light is likely to be absorbed in the processing liquid Lp and is unlikely to be absorbed in the water is set as the measurement wavelength, such that the temperature of the processing liquid Lp may be more accurately measured while suppressing the influence of the steam.

(4) The light emitted from the light emitting element 51 is light having a wavelength which is within a range of 350 nm to 1060 nm. For this reason, the light from the light emitting element 51 may be transmitted through the processing liquid Lp such as a phosphoric acid solution, thereby heating the substrate W such as a silicon wafer.

(5) The heater 50 includes the plurality of regions R in which the light emitting element 51 is arranged, the radiation thermometer 71 is provided at each of positions corresponding to the plurality of regions R, and the controller 80 is provided to control the output of the light emitting element 51 for each of the plurality of regions R, based on the temperature of the substrate W that is measured by the radiation thermometer 71. For this reason, the temperature of the entire region may become uniform in a case where the temperature is decreased as the processing liquid Lp supplied to the vicinity of the center of the substrate W spreads in the outer circumferential direction of the substrate W, or a temperature of a desired region R may be set as a high temperature or a low temperature in a case where the processing rate of the substrate W is to be partially changed.

(6) The plurality of regions R correspond to different positions in radial directions of the substrate W. For this reason, by changing the heating temperature for each of the areas on the concentric circles of the rotating substrate W, the processing rate may be uniform throughout the entire substrate W or be partially changed.

(7) A plurality of light emitting elements 51 are arranged to be capable of irradiating light on the entire surface of the substrate W to be processed. For this reason, the processing rate of the entire surface of the substrate W to be processed may be controlled.

(8) The elevator 60 is provided to elevate the heater 50. When the processing liquid Lp from the processing liquid supplier 20 is supplied to the substrate W, the elevator 60 locates the heater 50 at the heating position P2 closer to the substrate W than the position when the substrate W is loaded or unloaded. For this reason, a space in which the substrate W may be loaded or unloaded may be secured, and the substrate W may be efficiently heated by allowing the heater 50 to approach the substrate W during the processing.

### [Modifications]

(1) The processing by using the substrate processing apparatus 1 is not limited to the etching processing. Any apparatus may be used as long as the apparatus performs a processing by supplying the processing liquid Lp while heating the substrate W. For example, the processing may be a resist removal processing of removing a resist film formed on the substrate W.
(2) The processing liquid Lp is not limited to the phosphoric acid solution. Any processing liquid may be used as long as the processing liquid needs to be heated. For example, a fluoric acid and the like may be used. In addition, in the case of the resist removal processing, a sulfuric acid hydrogen peroxide aqueous solution (SPM) and the like may be used as the processing liquid Lp.
(3) The substrate W to be processed may be a Si substrate having a resist formed on a surface thereof. Further, the substrate W is not limited to the Si substrate. For example, a SiC substrate (silicon carbide wafer) may be used.
(4) The number, arranged positions, and the like of light emitting elements 51 are not limited to the aspect exemplified above. In addition, as long as a plurality of regions R are provided, and the number of regions R is not limited to 4. In addition, the temperature measurement by using the radiation thermometer 71 and the heating by using the light emitting element 51 may not be controlled in the plurality of divided regions R. The light from the light emitting element 51 may be guided on the substrate W via an optical fiber to be emitted. For this reason, the light emitting element 51 may not be located above the substrate W.
(5) In the above aspect, the rinse liquid nozzle 31 is configured to penetrate the support 52 and the cover 53, but a mechanism configured to move the rinse liquid nozzle 31 in the horizontal direction may be provided such that the rinse liquid nozzle 31 is moved above the vicinity of the center of the substrate W when the rinse liquid Lc is supplied.
(6) The support 52 where the light emitting element 51 is located is constituted as a circular member having a diameter which is equal to that of the substrate W or is larger than that of the substrate W, but is not limited thereto. With respect to the rotating substrate W, any member may be used as long as the member may irradiate light on the entire surface of the substrate W. For example, a rectangular member having a size with which the member may cover a radius of the substrate W may be used. In a case where light may be irradiated on a radial portion of the substrate W, the light may be irradiated on the entire surface of the substrate W while the substrate is rotated. In addition, the support 52 may be provided to be shakable in the horizontal direction to shake light emitted from the light emitting element 51, such that the light is irradiated on the entire surface of the substrate W.

As such, when the diameter of the support 52 is smaller than that of the substrate W, a mechanism configured to move the processing liquid nozzle 21 in the horizontal direction may be provided to move the processing liquid nozzle 21 above the substrate W when supplying the processing liquid. That is, the processing liquid nozzle 21 may be arranged anywhere as long as the processing liquid nozzle 21 may supply the processing liquid Lp toward the vicinity of the center of the substrate W while performing the irradiation of light from the light emitting element 51.

The light emitting element 51 may be located to heat the substrate W by irradiating light on the substrate W from below. In this case, a support configured to support the light emitting element 51 may be provided on the opposite surface 11a of the rotating table 11 such that the rotation from the driver 13 is not transmitted. Alternatively, a support configured to rotates at a rotation speed (revolution per unit time) different from that of the substrate W rotated by the rotating table 11 may be provided on the opposite surface 11a of the rotating table 11. However, like the above aspect, when the light from the light emitting element 51 is irradiated on a top surface of the substrate W, the substrate W can be heated by using, as the starting point, an interface of the substrate W with the processing liquid Lp, which is preferable.

(7) As for the radiation thermometer, any radiation thermometer may be used as long as the radiation thermometer may measure the temperature of the processing liquid Lp on the substrate W. For this reason, a mechanism configured to move the support of the radiation thermometer 71 in the horizontal direction may be provided to move the radiation thermometer 71 above the substrate W when temperature measurement is performed.

### [Other Embodiments]

In the above, although the embodiment of the present disclosure and the modification of each part have been described, the embodiment or the modification of each part is presented by way of example only, and is not intended to limit the scope of the present disclosure. The above-described novel embodiment may be embodied in a variety of other terms, and various omissions, substitutions, combinations, and changes may be made without departing from the spirit of the present disclosure. This embodiment or modification is included in the scope and gist of the present disclosure, and is also included in the scope of the present disclosure described in the claims.

According to the present disclosure in some embodiments, it is possible to control a processing rate of a substrate with a high precision.

While certain embodiments have been described, these embodiments have been presented by way of example only, and are not intended to limit the scope of the disclosures. Indeed, the embodiments described herein may be embodied in a variety of other forms. Furthermore, various omissions, substitutions and changes in the form of the embodiments described herein may be made without departing from the spirit of the disclosures. The accompanying claims and their equivalents are intended to cover such forms or modifications as would fall within the scope and spirit of the disclosures.

## Claims

1. A substrate processing apparatus (1) comprising:
a rotary holder (10) configured to hold and rotate a substrate;
a processing liquid supplier (20) configured to supply a processing liquid to the substrate, which is held and rotated by the rotary holder (10);
a heater (50) including at least one light emitting element (51, 51A, 51B, 51C, 51D) configured to emit light having a wavelength, which is absorbed in the substrate, and configured to heat the substrate by irradiating the light from the at least one light emitting element (51, 51A, 51B, 51C, 51D) to the substrate, which is held and rotated by the rotary holder (10); and
a temperature measurer (70) including a radiation thermometer (71, 71A, 71B, 71C, 71D) configured to measure a temperature of the processing liquid in a non-contact manner, based on light radiated from the processing liquid, and configured to measure the temperature of the processing liquid, which is heated by being in contact with the substrate, by using the radiation thermometer (71, 71A, 71B, 71C, 71D).

2. The substrate processing apparatus (1) of Claim 1, wherein the light having the wavelength from the at least one light emitting element (51, 51A, 51B, 51C, 51D) is transmitted through the processing liquid, and
wherein the heater (50) is provided to irradiate the light having the wavelength from the at least one light emitting element (51, 51A, 51B, 51C, 51D) from above a space in which the substrate is held by the rotary holder (10).

3. The substrate processing apparatus (1) of Claim 1 or 2, wherein the processing liquid supplied by the processing liquid supplier (20) is an aqueous solution containing a phosphoric acid, and
wherein a measurement wavelength of the radiation thermometer (71, 71A, 71B, 71C, 71D) is 2.2 *µ*m to 2.4 *µ*m.

4. The substrate processing apparatus (1) of any one of Claims 1 to 3, wherein the wavelength of the light emitted from the at least one light emitting element (51, 51A, 51B, 51C, 51D) is within a range of 350 nm to 1060 nm.

5. The substrate processing apparatus (1) of any one of Claims 1 to 4, wherein the heater (50) includes a plurality of regions in which the at least one light emitting element (51, 51A, 51B, 51C, 51D) is arranged,
wherein the radiation thermometer (71, 71A, 71B, 71C, 71D) is provided at each of positions corresponding to the plurality of regions, and
wherein the substrate processing apparatus (1) comprises a controller (80) configured to control an output of the at least one light emitting element (51, 51A, 51B, 51C, 51D) for each of the plurality of regions, based on a temperature of the processing liquid being in contact with the substrate, which is measured by the radiation thermometer (71, 71A, 71B, 71C, 71D).

6. The substrate processing apparatus (1) of Claim 5, wherein the plurality of regions correspond to positions at which radial directions of the substrate are different from each other.

7. The substrate processing apparatus (1) of any one of Claims 1 to 6, wherein the at least one light emitting element (51, 51A, 51B, 51C, 51D) includes a plurality of light emitting elements (51, 51A, 51B, 51C, 51D), which are arranged to be capable of irradiating light on an entire surface of the substrate that is processed.

8. The substrate processing apparatus (1) of any one of Claims 1 to 7, comprising an elevator (60) configured to elevate the heater (50),
wherein when the processing liquid is supplied from the processing liquid supplier (20) to the substrate, the elevator (60) locates the heater (50) at a heating position closer to the substrate than a position when the substrate is loaded or unloaded.
